# EUROPEAN PATENT APPLICATION

(11) **EP 2 495 750 A1**
(43) Date of publication of application: **05.09.2012**
(21) Application number: 10826455.7
(22) Date of filing: 27.09.2010
(51) Int. Cl.: H01L 21/02, C30B 29/36, H01L 21/20, H01L 21/205, H01L 21/336, H01L 29/12, H01L 29/78

(54) **SILICON CARBIDE SUBSTRATE PRODUCTION METHOD AND SILICON CARBIDE SUBSTRATE**

(30) Priority: 30.10.2009 JP 2009250483
(71) Applicant: Sumitomo Electric Industries, Ltd., Osaka-shi, Osaka 541-0041 (JP)
(72) Inventor: HARADA, Shin, Osaka-shi Osaka 554-0024 (JP); SASAKI, Makoto, Itami-shi Hyogo 664-0016 (JP); NISHIGUCHI, Taro, Itami-shi Hyogo 664-0016 (JP); TAMASO, Hideto, Osaka-shi Osaka 554-0024 (JP); NAMIKAWA, Yasuo, Osaka-shi Osaka 554-0024 (JP)
(74) Representative: Grünecker, Kinkeldey, Stockmair & Schwanhäusser
(86) International application number: PCT/JP2010/066704
(87) International publication number: WO 2011/052321

(57) **Abstract**

A method for manufacturing a silicon carbide substrate (1) includes the steps of: preparing a plurality of SiC substrates (20) each made of single-crystal silicon carbide; forming a base layer (10) made of silicon carbide and holding the plurality of SiC substrates (20), which are arranged side by side when viewed in a planar view; and forming a filling portion (60) filling a gap between the plurality of SiC substrates (20).

## Description

### TECHNICAL FIELD

The present invention relates to a method for manufacturing a silicon carbide substrate, and the silicon carbide substrate, more particularly, a method for readily manufacturing a silicon carbide substrate provided with a large diameter, and such a silicon carbide substrate.

### BACKGROUND ART

In recent years, in order to achieve high breakdown voltage, low loss, and utilization of semiconductor devices under a high temperature environment, silicon carbide (SiC) has begun to be adopted as a material for a semiconductor device. Silicon carbide is a wide band gap semiconductor having a band gap larger than that of silicon, which has been conventionally widely used as a material for semiconductor devices. Hence, by adopting silicon carbide as a material for a semiconductor device, the semiconductor device can have a high breakdown voltage, reduced on-resistance, and the like. Further, the semiconductor device thus adopting silicon carbide as its material has characteristics less deteriorated even under a high temperature environment than those of a semiconductor device adopting silicon as its material, advantageously.

In order to efficiently manufacture such semiconductor devices, it is effective to use a substrate having a large diameter. Accordingly, various studies have been conducted on silicon carbide substrates made of single-crystal silicon carbide and having a diameter of 3 inches or 4 inches as well as methods for manufacturing such silicon carbide substrates. For example, methods for manufacturing such silicon carbide substrates using a sublimation method have been proposed (for example, see US Patent Application Publication No. 2006/0073707 (Patent Literature 1), US Patent Application Publication No. 2007/0209577 (Patent Literature 2), and US Patent Application Publication No. 2006/0075958 (Patent Literature 3)).

### CITATION LIST

### PATENT LITERATURE

PTL 1: US Patent Application Publication No. 2006/0073707
PTL 2: US Patent Application Publication No. 2007/0209577
PTL 3: US Patent Application Publication No. 2006/0075958

### SUMMARY OF INVENTION

### TECHNICAL PROBLEM

In order to manufacture semiconductor devices more efficiently, it is required to provide a silicon carbide substrate with a larger diameter (4 inches or greater). Here, in order to fabricate a silicon carbide substrate having a large diameter using the sublimation method, temperature needs to be uniform in a wide area thereof. However, because the growth temperature of silicon carbide in the sublimation method is high, specifically, not less than 2000°C, it is difficult to control the temperature. Hence, it is not easy to have a wide area in which temperature is uniform. In addition, it is also difficult to achieve sufficient reproducibility for temperature distribution. Further, in fabricating a silicon carbide substrate using the sublimation method, it is difficult to check a process of crystal growth of silicon carbide. Even when the crystal growth of silicon carbide is done under seemingly the same conditions, substrates (crystals) obtained may differ in quality, disadvantageously. Accordingly, even when the sublimation method, which relatively readily allows for a large diameter, is used, it is not easy to fabricate a silicon carbide substrate excellent in crystallinity and having a large diameter (for example, 4 inches or greater), disadvantageously.

In view of these, an object of the present invention is to provide a method for manufacturing a silicon carbide substrate excellent in crystallinity and having a large diameter, as well as such a silicon carbide substrate.

### SOLUTION TO PROBLEM

A method for manufacturing a silicon carbide substrate according to the present invention includes the steps of: preparing a plurality of SiC substrates each made of single-crystal silicon carbide; forming a base layer made of silicon carbide and holding the plurality of SiC substrates, which are arranged side by side when viewed in a planar view; and forming a filling portion filling a gap between the plurality of SiC substrates.

In the method for manufacturing the silicon carbide substrate in the present invention, the base layer is formed to hold the plurality of SiC substrates each made of single-crystal silicon carbide and arranged side by side when viewed in a planar view. As described above, it is difficult for a substrate made of single-crystal silicon carbide to keep its high quality and have a large diameter. To address this, a plurality of high-quality SiC substrates each having a small diameter and obtained from a silicon carbide single crystal are arranged side by side when viewed in a planar view and a base layer supporting them is formed, thereby obtaining a silicon carbide substrate that is excellent in crystallinity and can be handled as a silicon carbide substrate having a large diameter.

Further, the surface of the silicon carbide substrate is usually smoothed by polishing or the like and then is used for manufacturing of semiconductor devices. However, when the plurality of SiC substrates are arranged side by side when viewed in a planar view, it is difficult to contact the SiC substrates with one another completely, with the result that gaps are formed between the SiC substrates. When such a surface of the silicon carbide substrate is polished, foreign matters such as abrasive particles come into the gaps. The foreign matters may not be completely removed even by a subsequent cleaning process. Further, the foreign matters thus remaining in the gaps between the SiC substrates may have a bad influence over the manufacturing of semiconductor devices using the silicon carbide substrate. To address this, in the method for manufacturing the silicon carbide substrate in the present invention, the filling portion is formed in the gap between the SiC substrates. Accordingly, adverse effect caused by the above-described foreign matters can be prevented.

As described above, according to the method for manufacturing the silicon carbide substrate in the present invention, a silicon carbide substrate excellent in crystallinity and having a large diameter can be manufactured. It should be noted that in order to improve the efficiency of the process of manufacturing a semiconductor device using the above-described silicon carbide substrate, it is preferable that adjacent ones of the plurality of SiC substrates are arranged in contact with one another. More specifically, for example, the plurality of SiC substrates are preferably arranged in contact with one another in the form of a matrix when viewed in a planar view. Further, the filling portion may be made of, for example, silicon carbide or silicon dioxide. The filling portion made of silicon carbide can be formed using, for example, a CVD (Chemical Vapor Deposition) epitaxial method, a sublimation method, a liquid phase epitaxy employing a Si melt, or the like. The liquid phase epitaxy employing the Si melt can be implemented by, for example, bringing the SiC substrates into contact with the Si melt retained in a carbon crucible to supply the gaps between the SiC substrates with Si from the melt and carbon from the crucible. On the other hand, a filling portion made of silicon dioxide can be formed using, for example, the CVD method.

The method for manufacturing the silicon carbide substrate may further include the step of smoothing main surfaces of the plurality of SiC substrates opposite to the base layer after the step of forming the filling portion.

Accordingly, when manufacturing semiconductor devices by forming an epitaxial layer made of for example, silicon carbide on each of the main surfaces of the SiC substrates thus having smoothness, the epitaxial layer can be provided with high crystallinity. The smoothing may be accomplished by, for example, a polishing process. On this occasion, in the method for manufacturing the semiconductor substrate in the present invention, the filling portion is formed to fill the gap between the SiC substrates, thus suppressing the problem caused by the foreign matters, such as abrasive particles, entering the gap.

The method for manufacturing the silicon carbide substrate may further include the step of forming an epitaxial growth layer made of single-crystal silicon carbide on main surfaces of the plurality of SiC substrates opposite to the base layer.

In this way, a semiconductor substrate can be manufactured which includes an epitaxial growth layer formed on the silicon carbide substrate and serving as a buffer layer or an active layer in a semiconductor device. On this occasion, because the base layer is formed after the plurality of high-quality SiC substrates are arranged side by side when viewed in a planar view, the base layer does not affect the quality of the SiC substrates even when the base layer includes many defects. This allows a high-quality epitaxial growth layer to be formed on the SiC substrates.

In the method for manufacturing the silicon carbide substrate, each of the end surfaces of the SiC substrates prepared in the step of preparing the plurality of SiC substrates may or may not be perpendicular to the main surface of each SiC substrate opposite to the side on which the base layer is to be formed. More specifically, for example, in the method for manufacturing the silicon carbide substrate, each of the plurality of SiC substrates prepared in the step of preparing the plurality of SiC substrates may have an end surface corresponding to a cleavage plane thereof.

With each of the end surfaces corresponding to the cleavage plane, damages on a vicinity of the end surface of each SiC substrate can be restrained upon obtaining the SiC substrate. As a result, crystallinity in the vicinity of the end surface of the SiC substrate can be maintained.

In the method for manufacturing the silicon carbide substrate, each of the plurality of SiC substrates prepared in the step of preparing the plurality of SiC substrates may have an end surface corresponding to a {0001} plane.

With the {0001} plane being a growth plane, an ingot of high-quality single-crystal silicon carbide can be fabricated efficiently. Further, the single-crystal silicon carbide can be cleaved at the {0001} plane. Hence, with each of the end surfaces corresponding to the {0001} plane, high-quality SiC substrates can be prepared efficiently.

In the method for manufacturing the silicon carbide substrate, in the step of forming the base layer, each of the SiC substrates may have a main surface opposite to the base layer and having an off angle of not less than 50° and not more than 65° relative to a {0001} plane.

By growing single-crystal silicon carbide of hexagonal system in the <0001 > direction, a high-quality single-crystal can be fabricated efficiently. From such a silicon carbide single-crystal grown in the <0001> direction, a silicon carbide substrate having a main surface corresponding to the {0001} plane can be obtained efficiently. Meanwhile, by using a silicon carbide substrate having a main surface having an off angle of not less than 50° and not more than 65° relative to the plane orientation of {0001}, a semiconductor device with high performance may be manufactured.

Specifically, for example, a silicon carbide substrate used for fabrication of a MOSFET generally has a main surface having an off angle of approximately 8° relative to a plane orientation of {0001}. An epitaxial growth layer is formed on this main surface and an oxide film, an electrode, and the like are formed on this epitaxial growth layer, thereby obtaining a MOSFET. In this MOSFET, a channel region is formed in a region including an interface between the epitaxial growth layer and the oxide film. However, in the MOSFET having such a structure, a lot of interface states are formed around the interface between the epitaxial growth layer and the oxide film, i.e., the location in which the channel region is formed, due to the substrate's main surface having an off angle of approximately 8° or smaller relative to the {0001} plane. This hinders traveling of carriers, thus decreasing channel mobility.

To address this, in the step of forming the base layer, by setting the main surface of the SiC substrate opposite to the base layer to have an off angle of not less than 50° and not more than 65° relative to the {0001} plane, the silicon carbide substrate to be manufactured will have a main surface having an off angle of not less than 50° and not more than 65° relative to the {0001} plane. This reduces formation of interface states. Hence, a MOSFET with reduced on-resistance can be fabricated.

In the method for manufacturing the silicon carbide substrate, in the step of forming the base layer, the main surface of each of the SiC substrates opposite to the base layer may have an off orientation forming an angle of 5° or smaller relative to a <1-100> direction.

The <1-100> direction is a representative off orientation in a silicon carbide substrate. Variation in the off orientation resulting from variation in a slicing process of the process of manufacturing the substrate is adapted to be 5° or smaller, which allows an epitaxial growth layer to be formed readily on the silicon carbide substrate.

In the above-described method for manufacturing the silicon carbide substrate, in the step of forming the base layer, the main surface of the SiC substrate opposite to the base layer may have an off angle of not less than -3° and not more than 5° relative to a {03-38} plane in the <1-100> direction.

Accordingly, channel mobility can be further improved in the case where a MOSFET is fabricated using the silicon carbide substrate. Here, setting the off angle at not less than -3° and not more than +5° relative to the plane orientation of {03-38} is is based on a fact that particularly high channel mobility was obtained in this set range as a result of inspecting a relation between the channel mobility and the off angle.

Further, the "off angle relative to the {03-38} plane in the <1-100> direction" refers to an angle formed by an orthogonal projection of a normal line of the above-described main surface to a flat plane defined by the <1-100> direction and the <0001> direction, and a normal line of the {03-38} plane. The sign of positive value corresponds to a case where the orthogonal projection approaches in parallel with the <1-100> direction whereas the sign of negative value corresponds to a case where the orthogonal projection approaches in parallel with the <0001> direction.

It should be noted that the main surface preferably has a plane orientation of substantially {03-38}, and the main surface more preferably has a plane orientation of {03-38}. Here, the expression "the main surface has a plane orientation of substantially {03-38}" is intended to encompass a case where the plane orientation of the main surface of the substrate is included in a range of off angle such that the plane orientation can be substantially regarded as {03-38} in consideration of processing accuracy of the substrate. In this case, the range of off angle is, for example, a range of off angle or ±2' relative to {03-38}. Accordingly, the above-described channel mobility can be further improved.

In the method for manufacturing the silicon carbide substrate, in the step of forming the base layer, the main surface of the SiC substrate opposite to the base layer has an off orientation forming an angle of not more than 5° relative to the <1 l-20> direction.

The <11-20> direction is a representative off orientation in a silicon carbide substrate, as with the <1-100> direction. Variation in the off orientation resulting from variation in the slicing process of the process of manufacturing the substrate is adapted to be ±5°, which allows an epitaxial growth layer to be formed readily on the silicon carbide substrate.

In the method for manufacturing the silicon carbide substrate, each of the SiC substrates prepared in the step of preparing the plurality of SiC substrates may have a micro pipe density of not more than 1 cm⁻².

Further, in the method for manufacturing the silicon carbide substrate, each of the SiC substrates prepared in the step of preparing the plurality of SiC substrates may have a dislocation density of not more than 1 × 10⁴ cm⁻².

Further, in the method for manufacturing the silicon carbide substrate, each of the SiC substrates prepared in the step of preparing the plurality of SiC substrates may have a stacking fault density of not more than 0.1 cm⁻¹.

By manufacturing the silicon carbide substrate using the high-quality SiC substrates thus prepared, yield can be improved in fabricating semiconductor devices using the silicon carbide substrate.

In the method for manufacturing the silicon carbide substrate, each of the SiC substrates prepared in the step of preparing the plurality of SiC substrates may have an impurity concentration greater than 5 × 10¹⁸ cm⁻³ and smaller than 2 × 10¹⁹ cm⁻³.

When the impurity concentration of each of the SiC substrates is equal to or smaller than 5 × 10¹⁸ cm⁻³, the resistivity of the SiC substrate becomes too large. On the other hand, when the impurity concentration thereof exceeds 2 × 10¹⁹ cm⁻³, it is difficult to restrain stacking faults in the SiC substrate. With the impurity concentration of the SiC substrate being set at more than 5 × 10¹⁸ g cm⁻³ and less than 2 × 10¹⁹ cm⁻³, the resistivity can be reduced while suppressing the stacking fault of the SiC substrate.

In the method for manufacturing the silicon carbide substrate, in the step of forming the base layer, a base layer may be formed which has an impurity concentration greater than 5 × 10¹⁸ cm⁻³.

Accordingly, the resistivity of the base layer can be reduced, thereby manufacturing a silicon carbide substrate suitable for manufacturing a vertical type semiconductor device (semiconductor device in which a current flows in the thickness direction of the substrate). Here, as described above, even in the case where the base layer includes many defects, the quality of the SiC substrate is not affected. Hence, in order to further reduce the resistivity of the base layer, in the step of forming the base layer, a base layer may be formed which has an impurity concentration exceeding 2 × 10¹⁹ cm⁻³.

In the method for manufacturing the silicon carbide substrate, the filling portion formed in the step of forming the filling portion may have an impurity concentration greater than 5 × 10¹⁸ cm⁻³.

In this way, the resistivity of the filling portion is reduced, thereby preventing the resistivity of the silicon carbide substrate from increasing due to the formation of the filling portion. Further, because the filling portion is formed after forming the base layer supporting the SiC substrates, the filling portion does not affect the quality of the SiC substrates even when the filling portion includes many defects. Hence, in order to further reduce the resistivity of the filling portion, in the step of forming the filling portion, a filling portion may be formed which has an impurity concentration exceeding 2 × 10¹⁹ cm⁻³.

Here, the term "impurity" in the present application indicates an impurity to be introduced to generate majority carriers in silicon carbide constituting the silicon carbide substrate. In the case where the majority carriers are, for example, electrons, i.e., where the impurity is an n type impurity, an impurity usable therefor is nitrogen, phosphorus, or the like. Phosphorus is capable of further reducing the resistivity of silicon carbide when introduced at the same concentration as that of nitrogen. Accordingly, by employing phosphorus as the impurity, the on-resistance of a semiconductor device can be reduced when fabricating semiconductor devices using the silicon carbide substrate.

The method for manufacturing the silicon carbide substrate may further include the steps of: forming a detachment facilitation region by providing proton radiation to the SiC substrates before the step of forming the base layer, so as to implant hydrogen ions into a region extending along a main surface of each of the SiC substrates on which the base layer is to be formed; and detaching the SiC substrates from the base layer at the detachment facilitation region after the step of forming the filling portion.

By employing such a process, a silicon carbide substrate including no base layer described above can be manufactured readily.

In the method for manufacturing the silicon carbide substrate, the step of forming the base layer may be performed before the step of forming the base layer, without polishing a main surface of each of the SiC substrates on which the base layer is to be formed.

Accordingly, the manufacturing cost of the silicon carbide substrate can be reduced. Here, in the step of forming the base layer, the main surfaces of the SiC substrates, on which the base layer is to be formed, may not be polished. However, for removal of damaged layers in the vicinity of surfaces formed by slicing upon fabricating the substrate, it is preferable to perform the step of forming the base layer after performing a step of removing the damaged layers by means of etching, for example.

A silicon carbide substrate according to the present invention includes: a plurality of SiC layers each made of single-crystal silicon carbide and arranged side by side when viewed in a planar view; and a filling portion filling a gap between the plurality of SiC layers.

In the silicon carbide substrate of the present invention, the plurality of SiC layers each made of single-crystal silicon carbide are arranged side by side when viewed in a planar view. In this way, there can be obtained a silicon carbide substrate which effectively utilizes high-quality SiC substrates each having a small diameter and obtained from a silicon carbide single-crystal, and which is excellent in crystallinity and can be handled as a silicon carbide substrate having a large diameter. Further, in the silicon carbide substrate of the present invention, the filling portion is formed to fill the gap between the SiC layers. In this way, when the surface of the silicon carbide substrate is polished, foreign matters such as abrasive particles are restrained from coming into the gap between the SiC layers.

As described above, according to the silicon carbide substrate in the present invention, a silicon carbide substrate excellent in crystallinity and having a large diameter can be obtained. It should be noted that in order to improve the efficiency of the process of manufacturing a semiconductor device using the above-described silicon carbide substrate, it is preferable that adjacent ones of the plurality of SiC layers are arranged in contact with one another. More specifically, for example, the plurality of SiC layers are preferably arranged in contact with one another in the form of a matrix. Further, the filling portion may be made of, for example, silicon carbide or silicon dioxide.

In the silicon carbide substrate, the impurity concentration of each SiC layer can be more than 5 × 10¹⁸ cm⁻³ and less than 2 × 10¹⁹ cm⁻³.

When the impurity concentration of each of the SiC layers is equal to or smaller than 5 × 10¹⁸ cm⁻³, the resistivity of the SiC layer becomes too large. On the other hand, when the impurity concentration thereof exceeds 2 × 10¹⁹ cm⁻³, it is difficult to restrain stacking faults in the SiC layer. With the impurity concentration of the SiC layer being set at more than 5 × 10¹⁸ cm⁻³ and less than 2 × 10¹⁹ cm⁻³, the resistivity can be reduced while suppressing the stacking fault of the SiC layer.

In the silicon carbide substrate, the filling portion can have an impurity concentration greater than 5 × 10¹⁸ cm⁻³.

In this way, the resistivity of the filling portion is reduced, thereby preventing the resistivity of the silicon carbide substrate from increasing due to the formation of the filling portion. Further, because the filling portion can be formed after arranging the SiC substrates (SiC layers) side by side when viewed in a planar view, the quality of each of the SiC layers can be avoided from being influenced even when the filling portion has many defects. Hence, for further reduction of the resistivity of the filling portion, the filling portion may have an impurity concentration exceeding 2 x 10¹⁹ cm⁻³.

The silicon carbide substrate may further include a base layer made of silicon carbide and holding the plurality of SiC layers, which are arranged side by side when viewed in a planar view. Accordingly, the plurality of SiC layers arranged side by side when viewed in a planar view can be connected to one another firmly.

In the silicon carbide substrate, the base layer can have an impurity concentration more than 5 × 10¹⁸ cm⁻³.

Accordingly, the resistivity of the base layer can be reduced, thereby obtaining a silicon carbide substrate suitable for manufacturing a vertical type semiconductor device. Further, because the base layer can be formed after arranging the SiC substrates (SiC layers) side by side when viewed in a planar view, the quality of each of the SiC layers can be avoided from being influenced even when the base layer has many defects. Hence, for further reduction of the resistivity of the base layer, the base layer may have an impurity concentration exceeding 2 × 10¹⁹ cm⁻³.

In the silicon carbide substrate, a main surface of each of the SiC layers opposite to the base layer may be polished. This allows a high-quality epitaxial growth layer to be formed on the main surface of the SiC layer opposite to the base layer. As a result, a semiconductor device can be manufactured which includes the high-quality epitaxial growth layer as an active layer, for example. Namely, by employing such a structure, the silicon carbide substrate can be obtained which allows for manufacturing of a high-quality semiconductor device including the epitaxial layer formed on the SiC layer.

The silicon carbide substrate may further include an epitaxial growth layer made of single-crystal silicon carbide and formed on main surfaces of the plurality of SiC layers.

In this way, a semiconductor substrate can be provided which includes an epitaxial growth layer formed on the silicon carbide substrate and usable as, for example, a buffer layer or an active layer in a semiconductor device. On this occasion, a SiC layer obtained from a high-quality ingot can be employed for each of the SiC layers. Hence, a high-quality epitaxial growth layer can be formed on the SiC substrates.

Each of the end surfaces of the plurality of SiC layers may or may not be perpendicular to each of the main surfaces of the SiC layers. More specifically, for example, in the silicon carbide substrate, each of the plurality of SiC layers may have an end surface corresponding to a cleavage plane thereof.

With each of the end surfaces corresponding to the cleavage plane, damages on a vicinity of the end surface of the SiC layer can be restrained upon obtaining the SiC layer. As a result, crystallinity in the vicinity of the end surface of the SiC layer is maintained.

In the silicon carbide substrate, each of the plurality of SiC layers may have an end surface corresponding to a {0001} plane.

With the {0001} plane being a growth plane, an ingot of high-quality single-crystal silicon carbide can be fabricated efficiently. Further, the single-crystal silicon carbide can be cleaved at the {0001} plane. Hence, with each of the end surfaces corresponding to the {0001} plane, high-quality SiC layers can be obtained efficiently.

In the silicon carbide substrate, each of the SiC layers has a main surface having an off angle of not less than 50° and not more than 65° relative to a {0001} plane.

As such, in the silicon carbide substrate of the present invention, each of the main surfaces of the SiC layers is adapted to have an off angle of not less than 50° and not more than 65° relative to the {0001} plane, thereby reducing formation of interface states around an interface between an epitaxial growth layer and an oxide film, i.e., a location where a channel region is formed upon forming a MOSFET using the silicon carbide substrate, for example. Accordingly, a MOSFET with reduced on-resistance can be fabricated.

In the silicon carbide substrate, the main surface of each of the SiC layers has an off orientation forming an angle of 5° or smaller relative to a <1-100> direction.

The <1-100> direction is a representative off orientation in a silicon carbide substrate. Variation in the off orientation resulting from variation in a slicing process of the process of manufacturing the substrate is adapted to be 5° or smaller, which allows an epitaxial growth layer to be formed readily on the silicon carbide substrate.

In the silicon carbide substrate, the main surface of each of the SiC layers may have an off angle of not less than -3° and not more than 5° relative to a {03-38} plane in the <1-100> direction.

Accordingly, channel mobility can be further improved in the case where a MOSFET is fabricated using the silicon carbide substrate. Here, the "off angle relative to the {03-38} plane in the <1-100> direction" refers to an angle formed by an orthogonal projection of a normal line of the above-described main surface to a flat plane defined by the <1-100> direction and the <0001> direction, and a normal line of the {03-38} plane. The sign of positive value corresponds to a case where the orthogonal projection approaches in parallel with the <1-100> direction whereas the sign of negative value corresponds to a case where the orthogonal projection approaches in parallel with the <0001> direction.

Further, the main surface preferably has a plane orientation of substantially {03-38}, and the main surface more preferably has a plane orientation of {03-38}. Here, the expression "the main surface has a plane orientation of substantially {03-38}" is intended to encompass a case where the plane orientation of the main surface of the substrate is included in a range of off angle such that the plane orientation can be substantially regarded as {03-38} in consideration of processing accuracy of the substrate. In this case, the range of off angle is, for example, a range of off angle of ±2° relative to {03-38}. Accordingly, the above-described channel mobility can be further improved.

In the silicon carbide substrate, the off orientation of the main surface of the SiC layer may form an angle of 5° or smaller relative to the <11-20> direction.

The <11-20> direction is a representative off orientation in a silicon carbide substrate, as with the <1-100> direction. Variation in the off orientation resulting from variation in a slicing process of the process of manufacturing the substrate is adapted to be ±5°, which allows an epitaxial growth layer to be formed readily on silicon carbide substrate 1.

In the silicon carbide substrate, the SiC layer may have a micro pipe density of 1 cm⁻² or smaller. Further, in the silicon carbide substrate, the SiC layer may have a dislocation density of 1 × 10⁴ cm⁻² or smaller. Further, in the silicon carbide substrate, the SiC layer may have a stacking fault density of 0.1 cm⁻¹ or smaller.

By employing such high-quality SiC layers, yield can be improved in fabricating semiconductor devices using the silicon carbide substrate.

### ADVANTAGEOUS EFFECTS OF INVENTION

As apparent from the description above, according to the method for manufacturing the silicon carbide substrate as well as the silicon carbide substrate in the present invention, there can be provided a method for manufacturing a silicon carbide substrate excellent in crystallinity and having a large diameter, as well as such a silicon carbide substrate.

### BRIEF DESCRIPTION OF DRAWINGS

Fig. 1 is a schematic cross sectional view showing a structure of a silicon carbide substrate.
Fig. 2 is a schematic plan view showing the structure of the silicon carbide substrate.
Fig. 3 is a schematic cross sectional view showing the structure of the silicon carbide substrate having an epitaxial layer formed thereon.
Fig. 4 is a flowchart schematically showing a method for manufacturing the silicon carbide substrate.
Fig. 5 is a schematic cross sectional view for illustrating the method for manufacturing the silicon carbide substrate.
Fig. 6 is a schematic cross sectional view for illustrating the method for manufacturing the silicon carbide substrate.
Fig. 7 is a schematic cross sectional view showing a structure of a silicon carbide substrate in a second embodiment.
Fig. 8 is a flowchart schematically showing a method for manufacturing a silicon carbide substrate in a third embodiment.
Fig. 9 is a schematic cross sectional view for illustrating the method for manufacturing the silicon carbide substrate.
Fig. 10 is a schematic cross sectional view for illustrating the method for manufacturing the silicon carbide substrate.
Fig. 11 is a schematic cross sectional view for illustrating the method for manufacturing the silicon carbide substrate.
Fig. 12 is a schematic cross sectional view showing a structure of a silicon carbide substrate in a fourth embodiment.
Fig. 13 is a flowchart schematically showing a method for manufacturing the silicon carbide substrate in the fourth embodiment.
Fig. 14 is a schematic cross sectional view for illustrating the method for manufacturing the silicon carbide substrate.
Fig. 15 is a schematic cross sectional view showing a structure of a silicon carbide substrate in a fifth embodiment.
Fig. 16 is a flowchart schematically showing a method for manufacturing the silicon carbide substrate in the fifth embodiment.
Fig. 17 is a schematic cross sectional view for illustrating the method for manufacturing the silicon carbide substrate.
Fig. 18 is a schematic cross sectional view showing a structure of a silicon carbide substrate in a sixth embodiment.
Fig. 19 is a flowchart schematically showing a method for manufacturing the silicon carbide substrate in the sixth embodiment.
Fig. 20 is a schematic cross sectional view for illustrating the method for manufacturing the silicon carbide substrate.
Fig. 21 is a schematic cross sectional view for illustrating the method for manufacturing the silicon carbide substrate.
Fig. 22 is a schematic cross sectional view for illustrating the method for manufacturing the silicon carbide substrate.
Fig. 23 is a schematic cross sectional view showing a structure of a vertical type MOSFET.
Fig. 24 is a flowchart schematically showing a method for manufacturing the vertical type MOSFET.
Fig. 25 is a schematic cross sectional view for illustrating the method for manufacturing the vertical type MOSFET.
Fig. 26 is a schematic cross sectional view for illustrating the method for manufacturing the vertical type MOSFET.
Fig. 27 is a schematic cross sectional view for illustrating the method for manufacturing the vertical type MOSFET.
Fig. 28 is a schematic cross sectional view for illustrating the method for manufacturing the vertical type MOSFET.

### DESCRIPTION OF EMBODIMENTS

The following describes embodiments of the present invention with reference to figures. It should be noted that in the below-mentioned figures, the same or corresponding portions are given the same reference characters and are not described repeatedly.

### (First Embodiment)

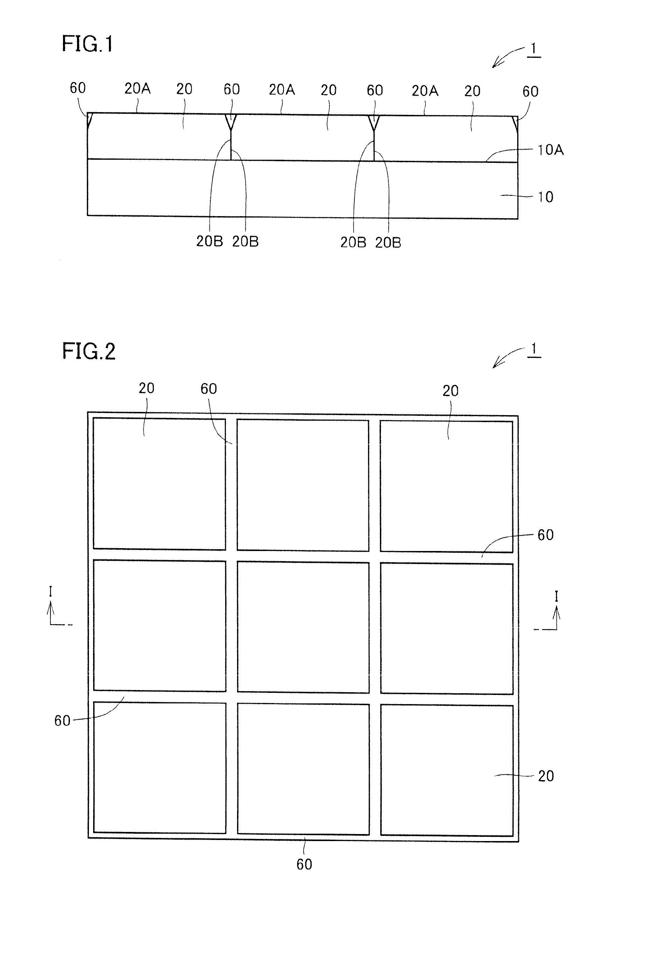

First, one embodiment, i.e., a first embodiment of the present invention will be described with reference to Fig. 1 and Fig. 2. Fig. 1 corresponds to a cross sectional view taken along a line I-I in Fig. 2. Referring to Fig. 1, a silicon carbide substrate 1 in the present embodiment includes: a plurality of SiC layers 20 each made of single-crystal silicon carbide and arranged side by side when viewed in a planar view; filling portions 60 filling gaps between the plurality of SiC layers 20; and a base layer 10 made of silicon carbide and holding the plurality of SiC layers 20 arranged side by side when viewed in a planar view. Namely, base layer 10 has a main surface 10A on which the plurality of SiC layers 20 are arranged side by side when viewed in a planar view. Filling portions 60 are formed in the gaps between the plurality of SiC layers 20, thereby filling the gaps. Each of filling portions 60 may be made of, for example, silicon carbide or silicon dioxide.

In silicon carbide substrate 1 of the present embodiment, the plurality of SiC layers 20 each made of single-crystal silicon carbide are arranged side by side when viewed in a planar view. As such, silicon carbide substrate 1 effectively utilizes the SiC substrates each obtained from a silicon carbide single-crystal having a small diameter and readily achieving high quality, whereby silicon carbide substrate 1 can be handled as a silicon carbide substrate excellent in crystallinity and having a large diameter. Further, because filling portion 60 are formed to fill the gaps between SiC layers 20 in silicon carbide substrate 1, foreign matters such as abrasive particles are restrained from entering each gap between SiC layers 20 even when the surface thereof is polished. Thus, silicon carbide substrate 1 is excellent in crystallinity and has a large diameter.

Further, referring to Fig. 1 and Fig. 2, in silicon carbide substrate 1, adjacent ones of the plurality of SiC layers 20 are disposed such that their end surfaces 20B are in contact with each other. More specifically, for example, the plurality of SiC layers 20 are arranged in contact with one another in the form of a matrix. Accordingly, silicon carbide substrate 1 is readily provided with a large diameter. In addition, utilization of silicon carbide substrate 1 having such a large diameter allows for efficient manufacturing process of semiconductor devices. Further, in silicon carbide substrate 1, each of end surfaces 20B of SiC layers 20 is perpendicular to main surface 20A thereof. This allows SiC layers 20 to be readily arranged in the form of a matrix. It should be noted that a space between adjacent SiC layers 20 is preferably 100 µm or smaller, more preferably, 10 µm or smaller.

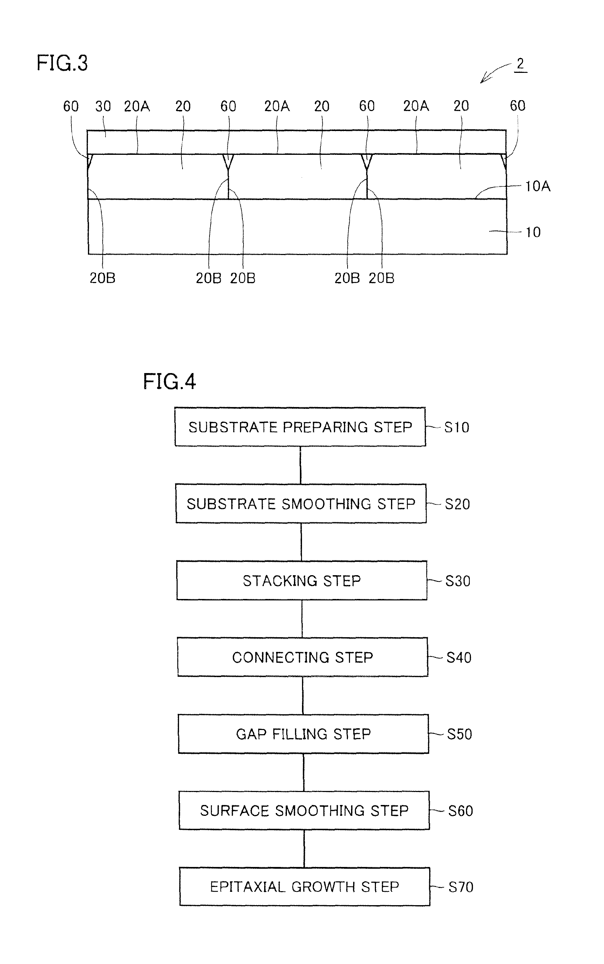

Further, when an epitaxial growth layer 30 made of single-crystal silicon carbide is formed on main surface 20A of each SiC layer 20 opposite to base layer 10 as shown in Fig. 3, stacking faults are not generated in base layer 10 and therefore are not generated also in epitaxial growth layer 30. Accordingly, for example, even when the impurity concentration of base layer 10 is made high in order to achieve reduced resistivity, stacking fault density becomes low in epitaxial growth layer 30.

Here, in silicon carbide substrate 1, the impurity included in base layer 10 may differ from the impurity included in each of SiC layers 20. Accordingly, a silicon carbide substrate can be obtained which has appropriate impurities depending on purpose of use. Further, the impurity included in each of base layer 10 can be nitrogen or phosphorus. The impurity included in each of SiC layers 20 can be nitrogen or phosphorus. In particular, by adopting phosphorus as the impurity, the resistivity of the silicon carbide substrate can become smaller than the resistivity thereof in the case where nitrogen is adopted as the impurity, with their impurity concentrations being the same.

Here, in silicon carbide substrate 1 described above, main surface 20A of each of SiC substrates 20 may have an off angle of not less than 50° and not more than 65° relative to the {0001} plane. By fabricating a MOSFET using such a silicon carbide substrate 1, formation of interface states can be reduced in a channel region, thereby obtaining a MOSFET reduced in on-resistance. Meanwhile, in order to facilitate the manufacturing, main surface 20A of SiC layer 20 may correspond to the {0001} plane.

Further, the off orientation of main surface 20A of SiC layer 20 may form an angle of 5° or less relative to the <1-100> direction. The <1-100> direction is a representative off orientation in a silicon carbide substrate. Variation in the off orientation resulting from variation in a slicing process of the process of manufacturing the substrate is adapted to be 5° or smaller, which allows an epitaxial growth layer to be formed readily on silicon carbide substrate 1.

Further, in silicon carbide substrate 1, main surface 20A of SiC layer 20 preferably has an off angle of not less than -3° and not more than 5° relative to the {03-38} plane in the <1-100> direction. Accordingly, channel mobility can be further improved in the case where a MOSFET is fabricated using silicon carbide substrate 1.

Meanwhile, in silicon carbide substrate 1, the off orientation of main surface 20A of SiC layer 20 may form an angle of 5° or smaller relative to the <1 1-20> direction.

<11-20> is also a representative off orientation in a silicon carbide substrate. Variation in the off orientation resulting from variation in a slicing process of the process of manufacturing the substrate is adapted to be ±5°, which allows an epitaxial growth layer to be formed readily on silicon carbide substrate 1.

Further, each of SiC layers 20 desirably has an impurity concentration greater than 5 × 10¹⁸ cm⁻³ and smaller than 2 × 10¹⁹ cm⁻³. In this way, the resistivity can be reduced while restraining stacking faults in SiC layer 20.

Further, each filling portion 60 has an impurity concentration of more than 5 × 10¹⁸ cm⁻³. This achieves reduced resistivity of filling portion 60, thereby preventing the resistivity of silicon carbide substrate 1 from increasing by forming filling portion 60.

Further, base layer 10 desirably has an impurity concentration of more than 5 × 10¹⁸ cm⁻³. Accordingly, the resistivity of base layer 10 can be reduced, and silicon carbide substrate 1 can be therefore a silicon carbide substrate suitable for manufacturing a vertical type semiconductor device.

Further, SiC layer 20 preferably has a micro pipe density of not more than 1 cm⁻². Further, SiC layer 20 preferably has a dislocation density of not more than 1 × 10⁴ cm⁻². Further, SiC layer 20 preferably has a stacking fault density of not more than 0.1 cm⁻¹. By employing such a high-quality SiC layer 20, yield can be improved in fabricating semiconductor devices using silicon carbide substrate 1.

Further, in silicon carbide substrate 1 of the present embodiment, main surface 20A of SiC layer 20 opposite to base layer 10 is preferably polished. This allows for formation of a high-quality epitaxial growth layer on main surface 20A. As a result, a semiconductor device can be manufactured which includes the high-quality epitaxial growth layer as an active layer, for example. Namely, by employing such a structure, silicon carbide substrate 1 can be obtained which allows for manufacturing of a high-quality semiconductor device including the epitaxial layer formed on SiC layer 20.

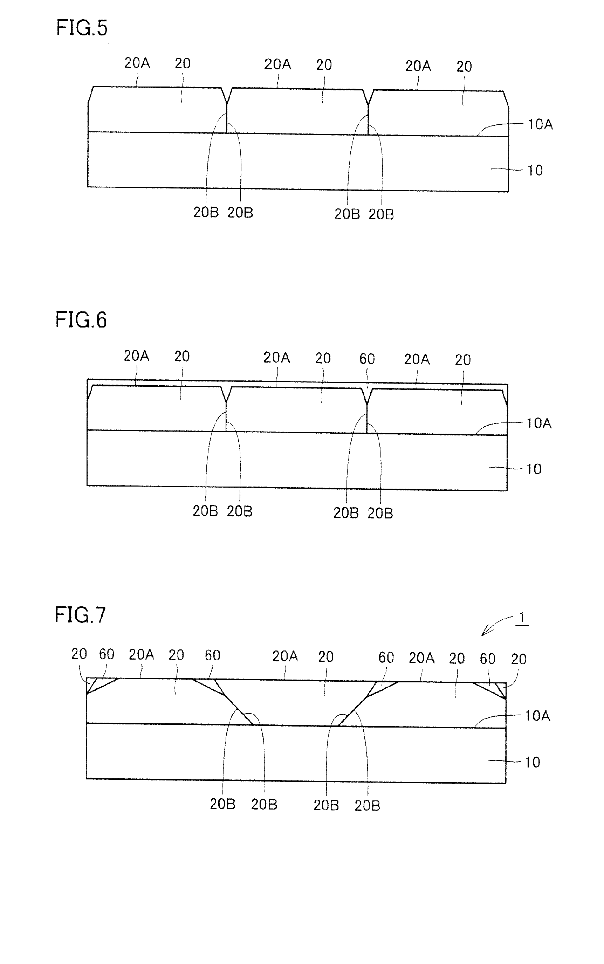

The following describes an exemplary method for manufacturing silicon carbide substrate 1 described above. Referring to Fig. 4, a substrate preparing step is first performed as a step (S10) in the method for manufacturing the silicon carbide substrate in the present embodiment. In this step (S10), referring to Fig. 5, base substrate 10 formed of for example single-crystal silicon carbide and the plurality of SiC substrates 20 each formed of single-crystal silicon carbide are prepared. Each of SiC substrates 20 has the main surface, which will be main surface 20A of SiC layer 20 that will be obtained by this manufacturing method (see Fig. 1). Hence, on this occasion, the plane orientation of the main surface of SiC substrate 20 is selected in accordance with desired plane orientation of main surface 20A. Here, for example, a SiC substrate 20 having a main surface corresponding to the {03-38} plane is prepared. Meanwhile, a substrate having an impurity concentration greater than, for example, 2 × 10¹⁹ cm⁻³ is adopted as base substrate 10. As each of SiC substrates 20, for example, a substrate is adopted which has an impurity concentration more than 5 × 10¹⁸ cm⁻³ and less than 2 × 10¹⁹ cm⁻³.

Next, a substrate smoothing step is performed as a step (S20). In this step (S20), referring to Fig. 5, base substrate 10 and a main surface of each SiC substrate 20 (connection surface) are smoothed by, for example, polishing. Base substrate 10 and the main surface of SiC substrate 20 are to be brought into contact with each other in a below-described step (S30). It should be noted that this step (S20) is not an essential step, but provides, if performed, a gap having a uniform size between base substrate 10 and SiC substrate 20, which are to face each other. Accordingly, in a below-described step (S40), uniformity is improved in reaction (connection) at the connection surface. This allows base substrate 10 and SiC substrate 20 to be connected to each other more securely.

Meanwhile, step (S20) may be omitted, i.e., step (S30) may be performed without polishing the main surfaces of base substrate 10 and SiC substrate 20, which are to face each other. This reduces manufacturing cost of silicon carbide substrate 1. Further, for removal of damaged layers located in surfaces formed by slicing upon fabrication of base substrate 10 and SiC substrate 20, a step of removing the damaged layers may be performed by, for example, etching instead of step (S20) or after step (S20), and then step (S30) described below may be performed.

Next, a stacking step is performed as step (S30). In this step (S30), referring to Fig. 5, SiC substrates 20 are placed on and in contact with main surface 10A of base substrate 10, thereby fabricating a stacked substrate. In doing so, adjacent SiC layers 20 are arranged in the form of matrix in contact with each other at their end surfaces 20B, when viewed in a planar view.

Next, as step (S40), a connecting step is performed. In step (S40), by heating the stacked substrate, base substrate 10 and each of SiC substrates 20 are connected to each other and adjacent SiC substrates 20 are connected to each other.

Next, as a step (S50), a gap filling step is performed. In this step (S50), a filling portion is formed to fill each of the gaps between the plurality of SiC substrates 20 connected to base substrate 10. Specifically, referring to Fig. 6, for example, a CVD epitaxial method is employed to grow silicon carbide, thereby forming a filling portion 60 that fills each gap between SiC substrates 20. It should be noted that the method for forming filling portion 60 is not limited to the CVD epitaxial method, and the sublimation method or liquid phase epitaxy may be employed, for example. The liquid phase epitaxy can be implemented by, for example, bringing SiC substrates 20 into contact with a Si melt retained in a carbon crucible to supply them with Si from the melt and carbon from the crucible. Further, filling portion 60 is not necessarily made of silicon carbide, and may be made of silicon dioxide, for example. A filling portion 60 made of silicon dioxide can be formed by, for example, the CVD method. Further, a filling portion 60 made of silicon (Si) or made of a resin may be employed. Filling portion 60 made of Si can be formed by, for example, introducing melted Si into each gap between SiC substrates 20. Filling portion 60 made of a resin can be formed by, for example, pouring a melted resin into each gap between SiC substrates 20 and then performing appropriate hardening treatment to harden the resin. Examples of the resin usable include an acrylic resin, an urethane resin, polypropylene, polystyrene, polyvinyl chloride, a resist, a SiC-containing resin, and the like.

Next, a surface smoothing step is performed as a step (S60). In this step (S60), main surface 20A of each SiC substrate 20 is smoothed by, for example, polishing. This allows a high-quality epitaxial growth layer to be formed on main surface 20A of SiC substrate 20. It should be noted that filling portion 60 formed on main surfaces 20A of SiC substrates 20 is removed by polishing. Further, filling portions 60 thus formed prevent foreign matters such as abrasive particles from entering the gaps between SiC layers 20. With the above-described process, silicon carbide substrate 1 of the present embodiment is completed which include, as SiC layer 20, SiC substrates 20 connected to one another (see Fig. 1).

Further, as a step (S70), an epitaxial growth step may be performed. In this step (S70), referring to Fig. 1 and Fig. 3, epitaxial growth layer 30 is formed on SiC layers 20. In this way, silicon carbide substrate 2 is completed which includes epitaxial growth layer 30 usable as a buffer layer or an active layer in a semiconductor device.

Here, in the stacked substrate fabricated in step (S30), the gap formed between base substrate 10 and each SiC substrate 20 is preferably 100 µm or smaller. Even when each of base substrate 10 and SiC substrates 20 has a high surface smoothness, there exists a slight warpage, undulation, or the like. Hence, in the stacked substrate, the gap is formed between base substrate 10 and each SiC substrate 20. If this gap is more than 100 µm, a state of connection between base substrate 10 and each of SiC substrates 20 may not become uniform. By setting the gap between base substrate 10 and each SiC substrate 20 to be not more than 100 µm, base substrate 10 and SiC substrates 20 can be uniformly connected to one another more securely.

Further, in step (S40), it is preferable to heat the above-described stacked substrate to fall within a range of temperature equal to or higher than the sublimation temperature of silicon carbide. This allows base substrate 10 and SiC substrate 20 to be connected to each other more securely. By setting the gap between base substrate 10 and each SiC substrate 20 in the stacked substrate to be not more than 100 µm, uniform connection therebetween can be attained by sublimation of SiC.

Further, heating temperature for the stacked substrate in step (S40) is preferably not less than 1800°C and not more than 2500°C. If the heating temperature is lower than 1800°C, it takes a long time to connect base substrate 10 and SiC substrate 20, which results in decreased efficiency in manufacturing silicon carbide substrate 1. On the other hand, if the heating temperature exceeds 2500°C, surfaces of base substrate 10 and SiC substrate 20 become rough, which may result in generation of a multiplicity of crystal defects in silicon carbide substrate 1 to be fabricated. In order to improve efficiency in manufacturing while restraining generation of defects in silicon carbide substrate 1, the heating temperature for the stacked substrate in step (S40) is preferably set at not less than 1900°C and not more than 2100°C. Further, when pressure of the atmosphere during heating in the above-described step (S40) is set at 10⁻⁵ Pa or greater and 10⁶ Pa or smaller, the above-described connection can be achieved using a simple device. Furthermore, in this step (S40), the stacked substrate may be heated under a pressure higher than 10⁻¹ Pa and lower than 10⁴ Pa. This can accomplish the above-described connection using a simple device, and provide an atmosphere for accomplishing the connection for a relatively short time, thereby achieving reduced manufacturing cost of silicon carbide substrate 1. Further, the atmosphere upon the heating in step (S40) may be inert gas atmosphere. In the case where the atmosphere is the inert gas atmosphere, the inert gas atmosphere preferably contains at least one selected from a group consisting of argon, helium, and nitrogen. Further, in this step (S40), the stacked substrate may be heated in an atmosphere obtained by reducing pressure of the atmospheric air. This reduces manufacturing cost of silicon carbide substrate 1.

Further, it has been illustrated in the above-described embodiment that: in step (S10), there are prepared SiC substrates 20 each having main surface 20A corresponding to the {03-38} plane; and in steps (S20) and (S30), main surface 20A of each SiC substrate 20 opposite to base substrate 10 corresponds to the {03-38} plane. However, instead of this, main surface 20A may have an off orientation corresponding to, for example, the <11-20> direction.

Further, each of SiC substrates 20 prepared in step (S10) preferably has a micro pipe density of not more than 1 cm⁻². Further, each of SiC substrates 20 prepared in step (S10) preferably has a dislocation density of not more than 1 × 10⁴ cm⁻². Further, each of SiC substrates 20 prepared in step (S10) preferably has a stacking fault density of not more than 0.1 cm⁻¹. By manufacturing silicon carbide substrate 1 with such high-quality SiC substrates 20 thus prepared, yield can be improved in fabricating semiconductor devices using silicon carbide substrate 1.

Further, each of SiC substrates 20 prepared in step (S10) preferably has an impurity concentration greater than 5 × 10¹⁸ cm⁻³ and smaller than 2 × 10¹⁹ cm⁻³. This allows for reduced resistivity while restraining stacking faults in each of SiC substrates 20.

Further, base substrate 10 prepared in step (S10) and connected to SiC substrates 20 in steps (S20) and (S30) preferably has an impurity concentration greater than 5 × 10¹⁸ cm⁻³. Accordingly, the resistivity of base layer 10 can be reduced, and silicon carbide substrate 1 can be therefore suitable for manufacturing a vertical type semiconductor device.

Further, filling portion 60 formed in step (S50) preferably has an impurity concentration greater than 5 × 10¹⁸ cm⁻³. This achieves reduced resistivity of filling portion 60, thereby preventing the resistivity of silicon carbide substrate 1 from increasing by forming filling portion 60.

### (Second Embodiment)

The following describes another embodiment of the present invention, i.e., a second embodiment. Referring to Fig. 7 and Fig. 1, a silicon carbide substrate 1 in the second embodiment has basically the same structure and provides basically the same effects as those of silicon carbide substrate 1 in the first embodiment. However, silicon carbide substrate 1 in the second embodiment is different from that of the first embodiment in terms of the shape of each of SiC layers 20.

Referring to Fig. 7, in the second embodiment, end surface 20B of each of SiC layers 20 is not perpendicular to main surface 20A thereof. Further, end surface 20B of SiC layer 20 in the second embodiment corresponds to a cleavage plane thereof. More specifically, in the second embodiment, end surface 20B of SiC layer 20 corresponds to the {0001} plane.

The following describes a method for manufacturing silicon carbide substrate 1 in the second embodiment. Silicon carbide substrate 1 in the second embodiment can be manufactured in basically the same way as in the first embodiment. However, the method for manufacturing the silicon carbide substrate in the second embodiment is different from that in the first embodiment in terms of the shape of each of SiC substrates 20 prepared in step (S 10).

Namely, referring to Fig. 7, in the substrate preparing step performed as step (S 10), SiC substrates 20 each corresponding to the shape of each SiC layer 20 in the second embodiment is prepared. Specifically, end surface 20B of each of SiC substrates 20 prepared in step (S 10) corresponds to the cleavage plane that is the {0001} plane. This restrains damages on a vicinity of the end surface of SiC substrate 20 when obtaining SiC substrate 20. As a result, crystallinity is maintained in the vicinity of the end surface of SiC substrate 20.

### (Third Embodiment)

The following describes still another embodiment of the present invention, i.e., a third embodiment. Referring to Fig. 1 and Fig. 2, a silicon carbide substrate 1 in the third embodiment has basically the same structure and provides basically the same effects as those of silicon carbide substrate 1 in the first embodiment. However, silicon carbide substrate 1 in the third embodiment is different from that of the first embodiment in terms of a method for manufacturing it.

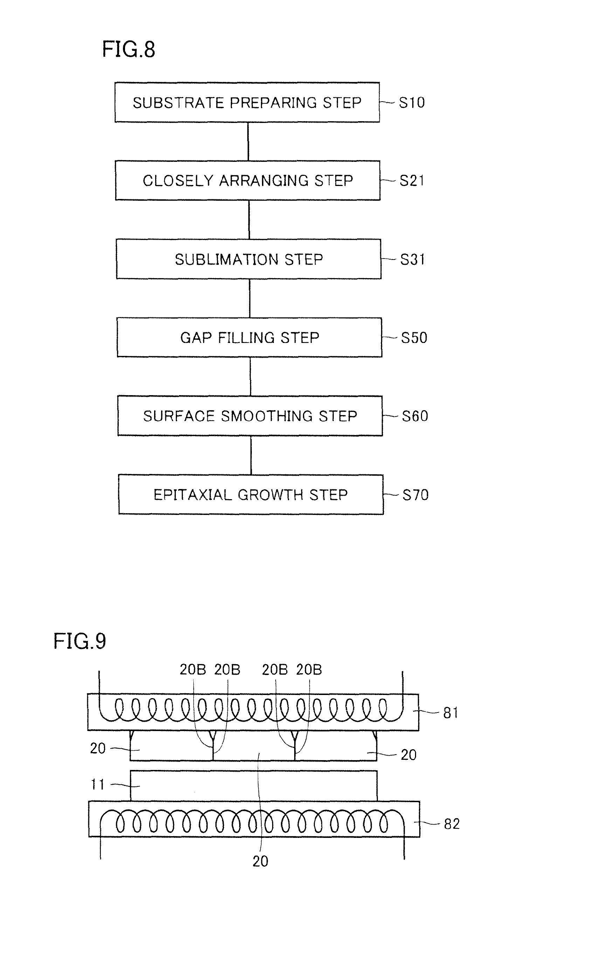

Referring to Fig. 8, in the method for manufacturing silicon carbide substrate 1 in the third embodiment, first, as a step (S 10), a substrate preparing step is performed. In this step (S10), as with the first embodiment, SiC substrates 20 are prepared and a material substrate made of silicon carbide are prepared.

Next, referring to Fig. 8, a closely arranging step is performed as a step (S21). In this step (S21), referring to Fig. 9, each SiC substrate 20 and material substrate 11 are held respectively by a first heater 81 and a second heater 82 disposed face to face each other. On this occasion, an appropriate value of a space between SiC substrate 20 and material substrate 11 is considered to be associated with a mean free path for a sublimation gas obtained upon heating in a below-described step (S31). Specifically, the average value of the space can be set to be smaller than the mean free path for the sublimation gas obtained upon heating in the below-described step (S31). For example, strictly, a mean free path for atoms and molecules depends on atomic radius and molecule radius at a pressure of 1 Pa and a temperature of 2000°C, but is approximately several cm to several ten cm. Hence, realistically, the space is preferably set at several cm or smaller. More specifically, SiC substrate 20 and material substrate 11 are arranged close to each other such that their main surfaces face each other with a space of not less than 1 µm and not more than 1 cm therebetween. The average value of the space is preferably 1 cm or smaller, more preferably, 1 mm or smaller. Meanwhile, with the average value of the space being 1 µm or greater, there can be secured a sufficient space for sublimation of silicon carbide. It should be noted that this sublimation gas is a gas formed by sublimation of solid silicon carbide, and includes Si, Si₂C, and SiC₂, for example.

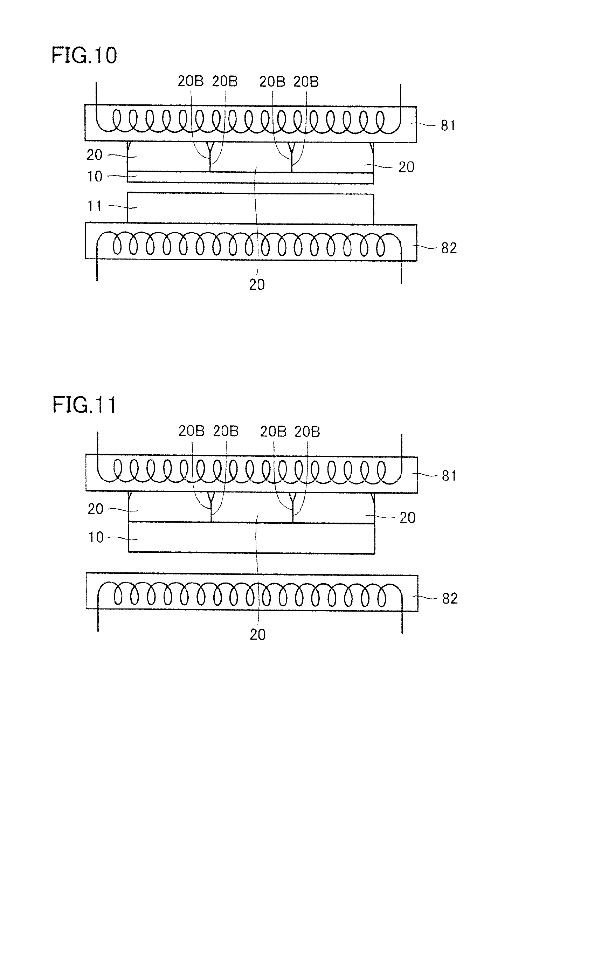

Next, as step (S31), a sublimation step is performed. In this step (S31), SiC substrates 20 are heated to a predetermined substrate temperature by first heater 81. Likewise, material substrate 11 is heated to a predetermined material temperature by second heater 82. On this occasion, material substrate 11 is heated to the sublimation temperature to sublimate SiC from a surface of the material substrate. On the other hand, the substrate temperature is set lower than the source material temperature. Specifically, for example, the substrate temperature is set lower than the material temperature by not less than 1°C and not more than 100°C. The substrate temperature is preferably 1800°C or greater and 2500°C or smaller. In this way, as shown in Fig. 10, gas of SiC sublimated from material substrate 11 reaches the surface of each SiC substrate 20 and is solidified thereon, thereby forming base layer 10. By maintaining this state, as shown in Fig. 11, all the SiC constituting material substrate 11 is sublimated and is accordingly transferred onto the surface of SiC substrate 20. In this way, step (S31) is completed. Thereafter, steps (S50) and (S60) are performed in the same way as in the first embodiment to complete silicon carbide substrate 1 shown in Fig. 1. Further, as with the first embodiment, by performing step (S70), a silicon carbide substrate 2 including an epitaxial growth layer 30 shown in Fig. 4 can be manufactured.

It has been illustrated that material substrate 11 is employed in the third embodiment described above as the source material for base layer 10, but base layer 10 may be formed by preparing source material powder made of silicon carbide instead of material substrate 11, and sublimating the source material powder.

### (Fourth Embodiment)

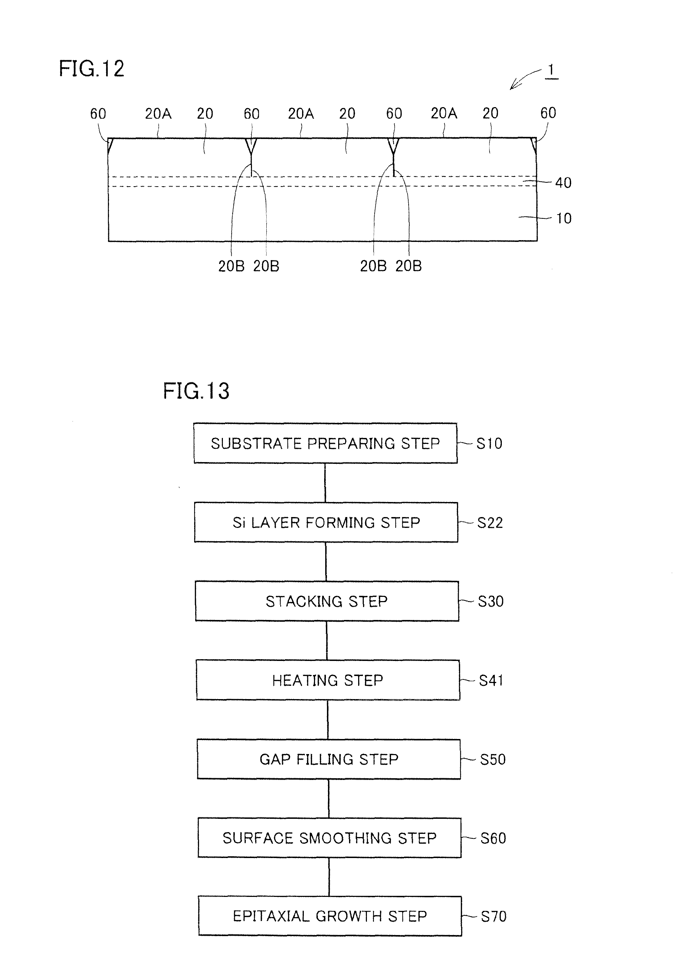

The following describes yet another embodiment of the present invention, i.e., a fourth embodiment. Referring to Fig. 12 and Fig. 1, a silicon carbide substrate 1 in the fourth embodiment has basically the same configuration and provides basically the same effects as those of silicon carbide substrate 1 in the first embodiment. However, silicon carbide substrate 1 in the fourth embodiment is different from that of the first embodiment in that an amorphous SiC layer serving as an intermediate layer is provided between base layer 10 and SiC layer 20.

Namely, referring to Fig. 12, in silicon carbide substrate 1 in the fourth embodiment, amorphous SiC layer 40 is provided between base layer 10 and SiC layer 20. Amorphous SiC layer 40 at least has a portion made of amorphous SiC, and serves as an intermediate layer. Base layer 10 and SiC layer 20 are connected to each other by this amorphous SiC layer 40. Amorphous SiC layer 40 thus existing facilitates fabrication of silicon carbide substrate 1 in which base layer 10 and SiC layer 20 are provided on each other.

The following describes a method for manufacturing silicon carbide substrate 1 in the fourth embodiment. Referring to Fig. 13, in the method for manufacturing silicon carbide substrate 1 in the fourth embodiment, the substrate preparing step is performed as step (S 10) in the same way as in the first embodiment, so as to prepare base substrate 10 and the plurality of SiC substrates 20.

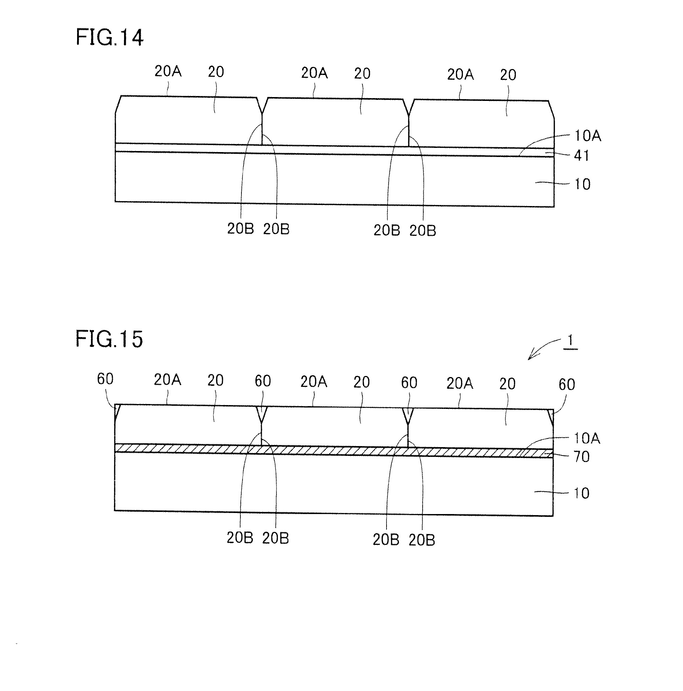

Next, a Si layer forming step is performed as a step (S22). In this step (S22), referring to Fig. 14, a Si layer 41 having a thickness of 100 nm is formed on one main surface 10A of base substrates 10 prepared in step (S 10), for example. This Si layer 41 can be formed using the sputtering method, for example.

Next, a stacking step is performed as step (S30). In this step (S30), as with the first embodiment, the plurality of SiC substrates 20 prepared in step (S10) are arranged side by side in the form of a matrix on Si layer 41 formed in step (S22). In this way, a stacked substrate is obtained in which SiC substrates 20 are provided on Si layer 41 provided on base substrate 10.

Next, as a step (S41), a heating step is performed. In this step (S41), the stacked substrate fabricated in step (S30) is heated, for example, in a mixed gas atmosphere of hydrogen gas and propane gas under a pressure of 1 × 10³ Pa at approximately 1500°C for 3 hours. Accordingly, Si layer 41 is supplied with carbon as a result of diffusion from base substrate 10 and SiC substrates 20, thereby forming amorphous SiC layer 40 as shown in Fig. 12. Thereafter, by performing steps (S50) and (S60) as with the first embodiment, silicon carbide substrate 1 in the fourth embodiment can be manufactured readily. Further, as with the first embodiment, by performing step (S70), a silicon carbide substrate including an epitaxial growth layer may be fabricated.

### (Fifth Embodiment)

The following describes still another embodiment of the present invention, i.e., a fifth embodiment. Referring to Fig. 15, a silicon carbide substrate 1 in the fifth embodiment has basically the same configuration and provides basically the same effects as those of silicon carbide substrate 1 in the first embodiment. However, silicon carbide substrate 1 in the fifth embodiment is different from that of the first embodiment in that an intermediate layer 70 is formed between base layer 10 and each SiC layer 20.

More specifically, intermediate layer 70 includes carbon to serve as a conductor. Here, intermediate layer 70 usable herein includes, for example, graphite particles and non-graphitizable carbon. Preferably, intermediate layer 70 has a carbon composite structure including graphite particles and non-graphitizable carbon.

Namely, in silicon carbide substrate 1 of the fifth embodiment, intermediate layer 70 serving as a conductor by including carbon therein is disposed between base layer 10 and SiC layer 20. Base layer 10 and SiC layer 20 are connected to each other via intermediate layer 70. Intermediate layer 70 thus existing facilitates fabrication of silicon carbide substrate 1 in which base layer 10 and SiC layer 20 are provided on each other.

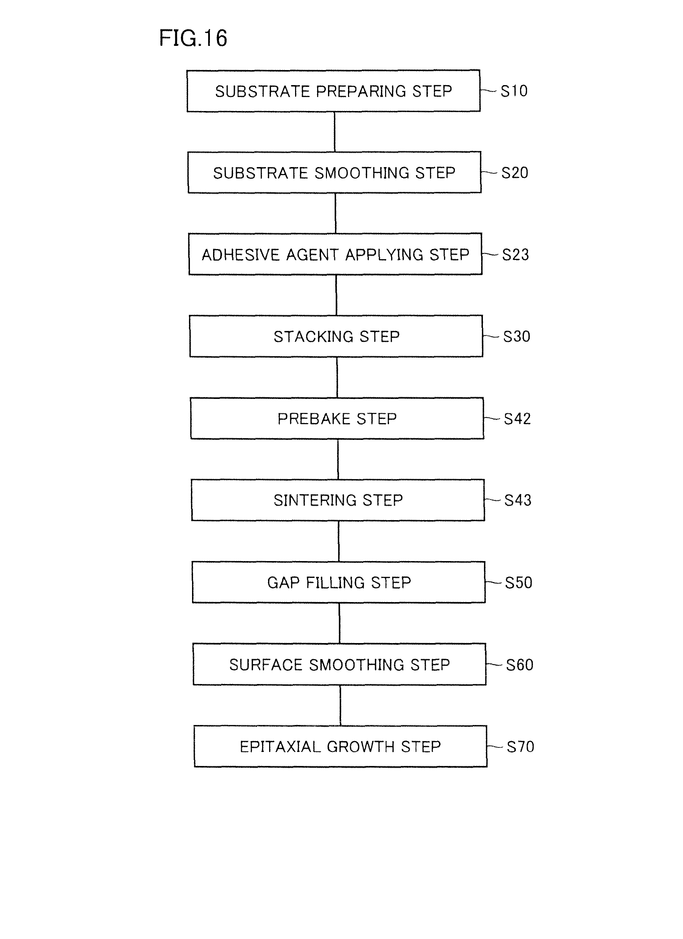

The following describes a method for manufacturing silicon carbide substrate 1 in the fifth embodiment. Referring to Fig. 16, in the method for manufacturing silicon carbide substrate 1 in the fifth embodiment, steps (S 10) and (S20) are performed in the same way as in the first embodiment.

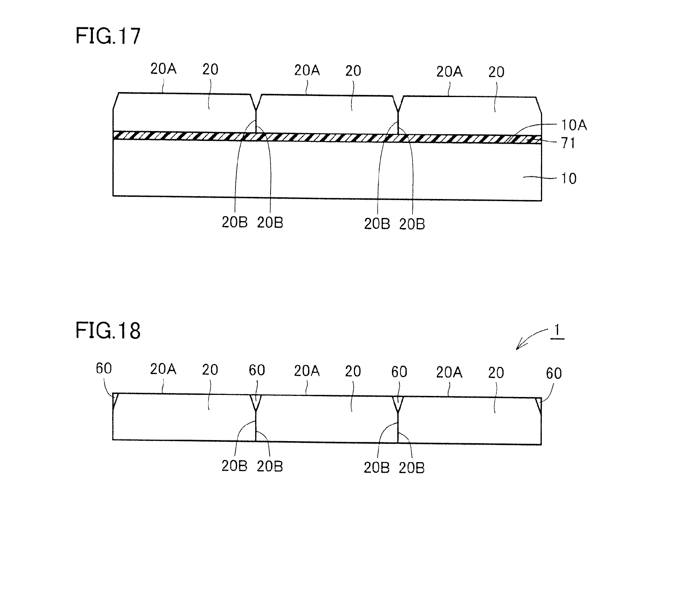

Next, as a step (S23), an adhesive agent applying step is performed. In this step (S23), referring to Fig. 17, for example, a carbon adhesive agent is applied to the main surface of base substrate 10, thereby forming a precursor layer 71. The carbon adhesive agent can be formed of, for example, a resin, graphite particles, and a solvent. Here, an exemplary resin usable is a resin formed into non-graphitizable carbon by heating, such as a phenol resin. An exemplary solvent usable is phenol, formaldehyde, ethanol, or the like. Further, the carbon adhesive agent is preferably applied at an amount of not less than 10 mg/cm² and not more than 40 mg/cm ² more preferably, at an amount of not less than 20 mg/cm² and not more than 30 mg/cm². Further, the carbon adhesive agent applied preferably has a thickness of not more than 100 µm, more preferably, not more than 50 µm.

Next, a stacking step is performed as step (S30). In this step (S30), referring to Fig. 17, the plurality of SiC substrates 20 are placed, in the form of matrix, on and in contact with precursor layer 71 formed on and in contact with main surface 10A of base substrate 10, thereby fabricating a stacked substrate.

Next, as a step (S42), a prebake step is performed. In this step (S42), the stacked substrate is heated, thereby removing a solvent component from the carbon adhesive agent constituting precursor layer 71. Specifically, the stacked substrate is gradually heated to a range of temperature exceeding the boiling point of the solvent component while applying a load to the stacked substrate in the thickness direction thereof, for example. This heating is preferably performed while pressing base substrate 10 and SiC substrates 20 against one another using a clamp or the like. Further, by performing the prebaking (heating) as long as possible, the adhesive agent is degassed to improve strength in adhesion.

Next, as a step (S43), a sintering step is performed. In this step (S43), the stacked substrate heated and accordingly prebaked in step (S42) are heated to a high temperature, preferably, not less than 900°C and not more than 1100°C, for example, 1000°C for preferably not less than 10 minutes and not more than 10 hours, for example, for 1 hour, thereby sintering precursor layers 71. Atmosphere employed upon the sintering can be inert gas atmosphere such as argon. The pressure of the atmosphere can be, for example, atmospheric pressure. In this way, precursor layers 71 are formed into intermediate layers 70 each made of carbon that is a conductor. Thereafter, steps (S50) and (S60) are performed in the same way as in the first embodiment. As a result, silicon carbide substrate 1 of the fifth embodiment is obtained in which base substrate (base layer) 10 and SiC substrate (SiC layer) 20 are connected to each other via intermediate layer 70. Further, as with the first embodiment, by performing step (S70), a silicon carbide substrate including an epitaxial growth layer may be fabricated.

It should be noted that the fourth and fifth embodiments have illustrated the intermediate layers including amorphous SiC and carbon respectively, but the intermediate layer is not limited to these. Instead of these, an intermediate layer made of a metal can be employed, for example. In this case, as the metal, it is preferable to employ a metal that can make ohmic contact with silicon carbide by forming a silicide, such as nickel.

### (Sixth Embodiment)

The following describes yet another embodiment of the present invention, i.e., a sixth embodiment. Referring to Fig. 18 and Fig. 1, a silicon carbide substrate 1 in the sixth embodiment has basically the same configuration and provides basically the same effects as those of silicon carbide substrate 1 in the first embodiment. However, silicon carbide substrate 1 in the sixth embodiment is different from that of the first embodiment in that it does not include base layer 10. Specifically, silicon carbide substrate 1 of the sixth embodiment can be handled as a freestanding substrate having adjacent SiC layers 20 connected to each other.

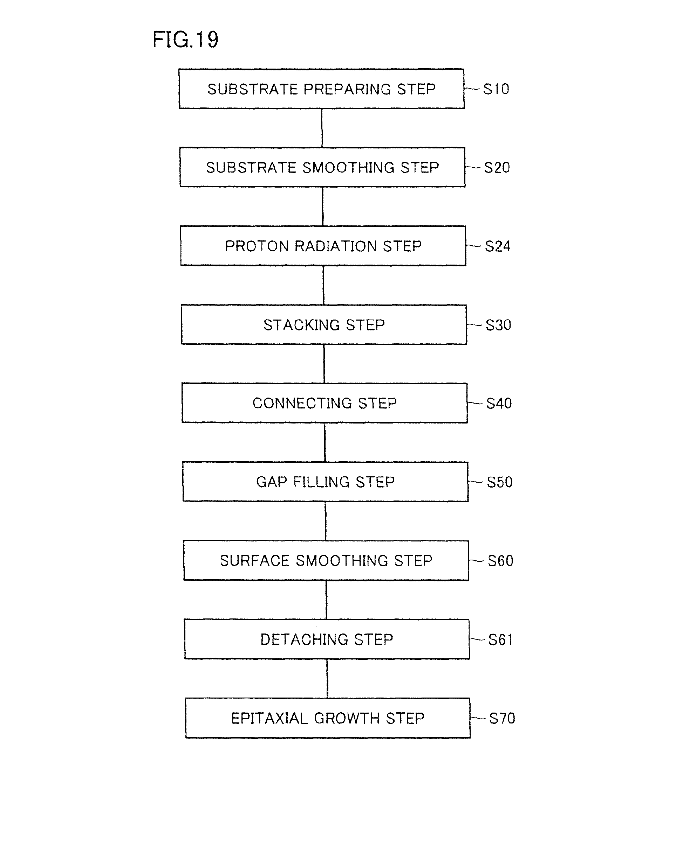

The following describes a method for manufacturing silicon carbide substrate 1 in the sixth embodiment. Referring to Fig. 19, in the method for manufacturing silicon carbide substrate 1 in the sixth embodiment, steps (S10) and (S20) are performed in the same way as in the first embodiment.

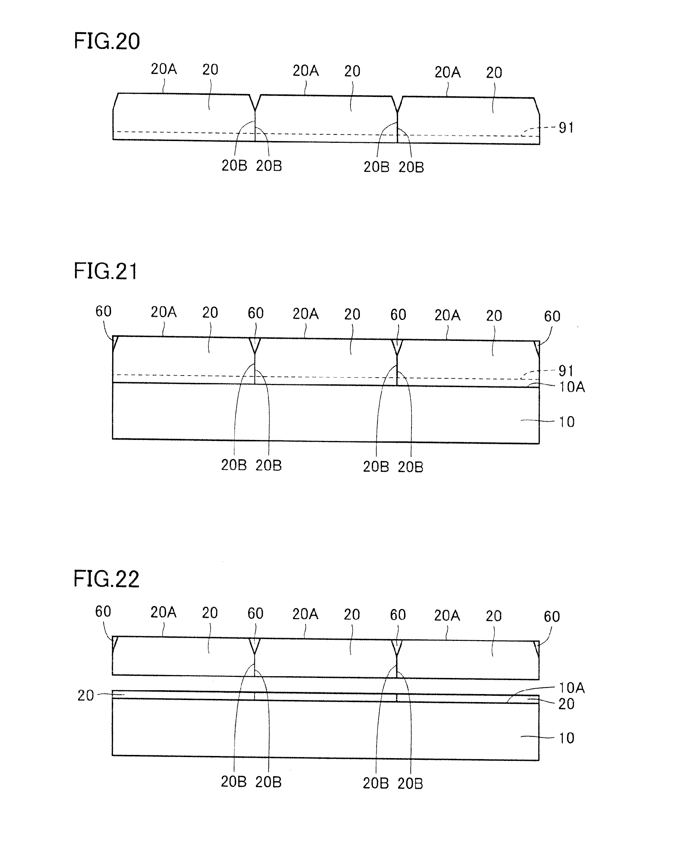

Next, as a step (S24), a proton radiation step is performed. In this step (S24), referring to Fig. 20, proton radiation is provided to SiC substrate 20 to form a detachment facilitation region 91 at a region extending along the main surfaces of SiC substrates 20 and located at a side at which base layer 10 is to be formed. In detachment facilitation region 91, hydrogen ions are implanted. Specifically, the hydrogen ions are implanted into SiC substrates 20 in a radiation amount falling within the range of, for example, not less than 3.5 × 10¹⁶ ions/cm² and not more than 1.0 × 10¹⁷ ions/cm².

Next, steps (S30)-(S60) are performed in the same way as in the first embodiment. Accordingly, as shown in Fig. 21, there can be obtained a silicon carbide substrate having a structure similar to that of silicon carbide substrate 1 of the first embodiment, and having detachment facilitation region 91 at its region extending along the main surfaces of SiC substrates 20 at the base layer 10 side.

Next, as a step (S61), a detaching step is performed. In this step (S6), as shown in Fig. 22, SiC substrates 20 are detached from base layer 10 via detachment facilitation region 91. Specifically, the silicon carbide substrate obtained by performing the steps up to step (S60) is subjected to, for example, heat treatment or mechanical impact to detach SiC substrates 20 from base layer 10. As a result, silicon carbide substrate 1 having no base layer 10 in the sixth embodiment is obtained. Further, as with the first embodiment, by performing step (S70), a silicon carbide substrate including an epitaxial growth layer may be fabricated.

### (Seventh Embodiment)

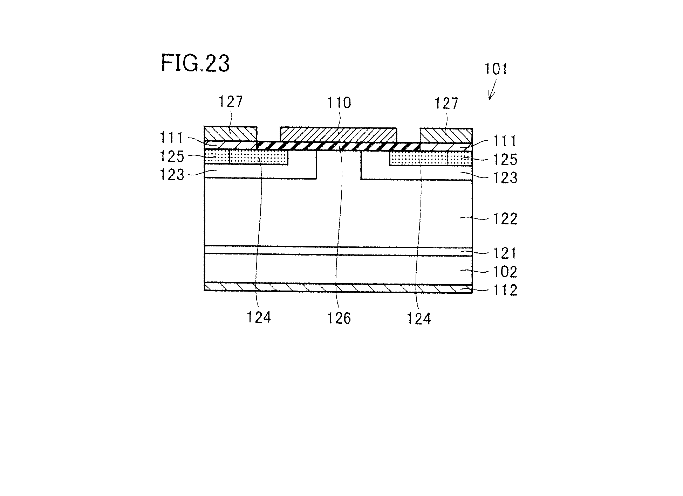

As a seventh embodiment, the following describes one exemplary semiconductor device fabricated using the above-described silicon carbide substrate of the present invention. Referring to Fig. 23, a semiconductor device 101 according to the present invention is a DiMOSFET (Double Implanted MOSFET) of vertical type, and has a substrate 102, a buffer layer 121, a breakdown voltage holding layer 122, p regions 123, n⁺ regions 124, p⁺ regions 125, an oxide film 126, source electrodes 111, upper source electrodes 127, a gate electrode 110, and a drain electrode 112 formed on the backside surface of substrate 102. Specifically, buffer layer 121 made of silicon carbide is formed on the front-side surface of substrate 102 made of silicon carbide of n type conductivity. As substrate 102, there is prepared a silicon carbide substrate of the present invention, inclusive of silicon carbide substrates 1 described in the first to sixth embodiments. In the case where silicon carbide substrate 1 in each of the first to sixth embodiments is employed, buffer layer 121 is formed on SiC layer 20 of silicon carbide substrate 1. Buffer layer 121 has n type conductivity, and has a thickness of, for example, 0.5 µm. Further, impurity with n type conductivity in buffer layer 121 has a concentration of, for example, 5 × 10¹⁷ cm⁻³. Formed on buffer layer 121 is breakdown voltage holding layer 122. Breakdown voltage holding layer 122 is made of silicon carbide of n type conductivity, and has a thickness of 10 µm, for example. Further, breakdown voltage holding layer 122 includes an impurity of n type conductivity at a concentration of, for example, 5 × 10¹⁵ cm⁻³.

Breakdown voltage holding layer 122 has a surface in which p regions 123 of p type conductivity are formed with a space therebetween. In each of p regions 123, an n⁺ region 124 is formed at the surface layer of p region 123. Further, at a location adjacent to n⁺ region 124, a p⁺ region 125 is formed. Oxide film 126 is formed to extend on n⁺ region 124 in one p region 123, p region 123, an exposed portion of breakdown voltage holding layer 122 between the two p regions 123, the other p region 123, and n⁺ region 124 in the other p region 123. On oxide film 126, gate electrode 110 is formed. Further, source electrodes 111 are formed on n⁺ regions 124 and p⁺ regions 125. On source electrodes 111, upper source electrodes 127 are formed. Moreover, drain electrode 112 is formed on the backside surface of substrate 102, i.e., the surface opposite to its front-side surface on which buffer layer 121 is formed.

Semiconductor device 101 in the present embodiment employs, as substrate 102, the silicon carbide substrate of the present invention, such as silicon carbide substrates 1 described in the first to sixth embodiments. Here, as described above, the silicon carbide substrate in the present invention is excellent in crystallinity and has a large diameter. Hence, in semiconductor device 101, buffer layer 121 and breakdown voltage holding layer 122 formed on substrate 102 as epitaxial layers are excellent in crystallinity, and manufacturing cost of semiconductor device 101 is reduced.

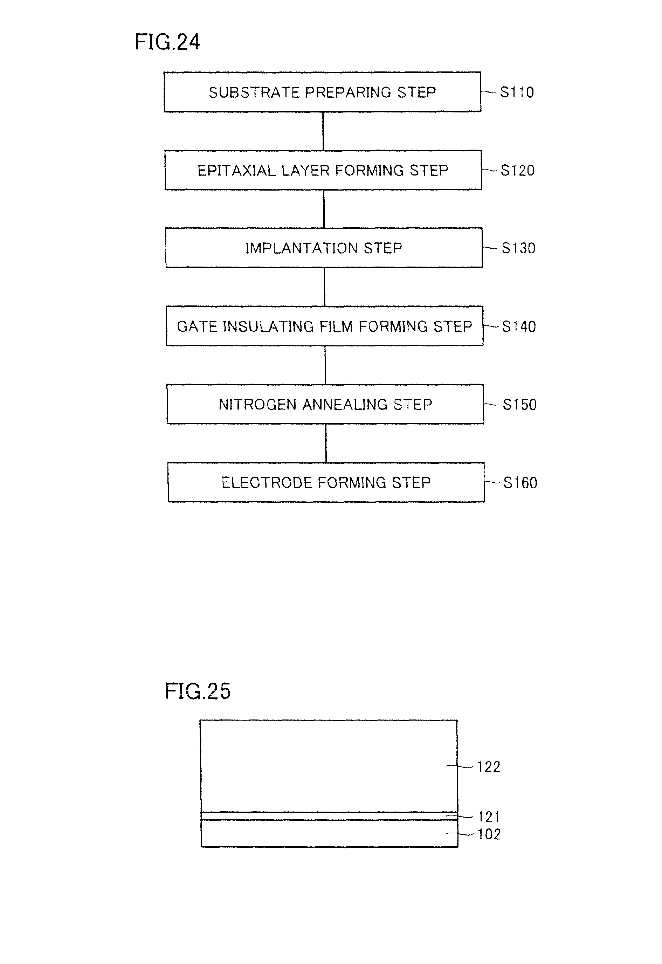

The following describes a method for manufacturing semiconductor device 101 shown in Fig. 23, with reference to Fig. 24-Fig. 28. Referring to Fig. 24, first, a substrate preparing step (S110) is performed. Prepared here is, for example, substrate 102, which is made of silicon carbide and has its main surface corresponding to the (03-38) plane (see Fig. 25). As substrate 102, there is prepared a silicon carbide substrate of the present invention, inclusive of silicon carbide substrate 1 manufactured in accordance with each of the manufacturing methods described in the first to sixth embodiments.

As substrate 102 (see Fig. 25), a substrate may be employed which has n type conductivity and has a substrate resistance of 0.02 Ωcm.

Next, as shown in Fig. 24, an epitaxial layer forming step (S 120) is performed. Specifically, buffer layer 121 is formed on the front-side surface of substrate 102. Buffer layer 121 is formed on SiC layer 20 (see Fig. 1, Fig. 7, Fig. 12, Fig. 15, and Fig. 18) of silicon carbide substrate 1 employed as substrate 102. As buffer layer 121, an epitaxial layer is formed which is made of silicon carbide of n type conductivity and has a thickness of 0.5 µm, for example. Buffer layer 121 has a conductive impurity at a concentration of, for example, 5 × 10¹⁷ cm⁻³. Then, on buffer layer 121, breakdown voltage holding layer 122 is formed as shown in Fig. 25. As breakdown voltage holding layer 122, a layer made of silicon carbide of n type conductivity is formed using an epitaxial growth method. Breakdown voltage holding layer 122 can have a thickness of, for example, 10 µm. Further, breakdown voltage holding layer 122 includes an impurity of n type conductivity at a concentration of, for example, 5 × 10¹⁵ cm⁻³.

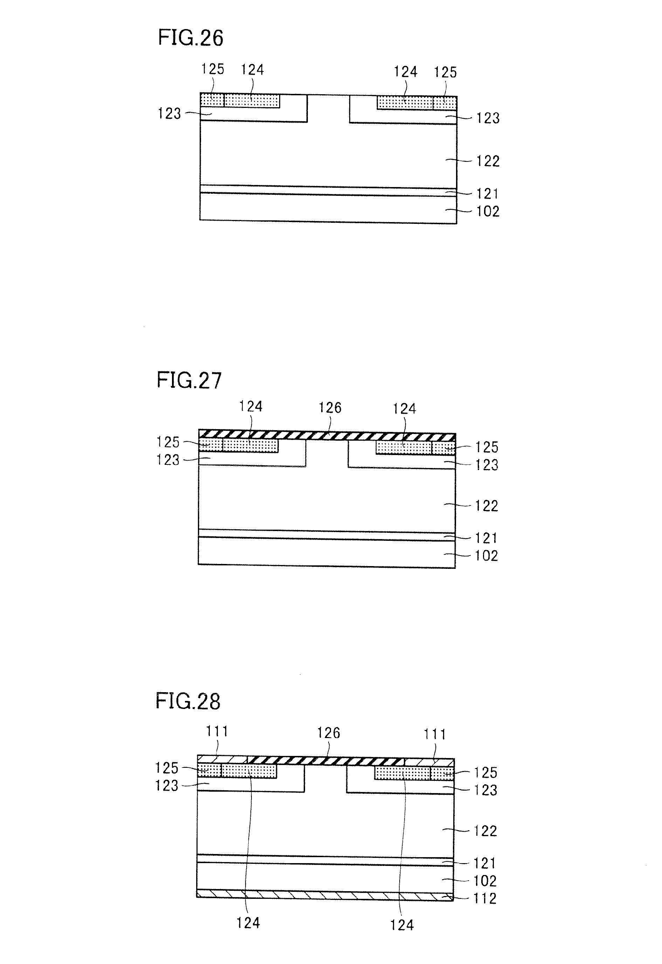

Next, as shown in Fig. 24, an implantation step (S 130) is performed. Specifically, an impurity of p type conductivity is implanted into breakdown voltage holding layer 122 using, as a mask, an oxide film formed through photolithography and etching, thereby forming p regions 123 as shown in Fig. 26. Further, after removing the oxide film thus used, an oxide film having a new pattern is formed through photolithography and etching. Using this oxide film as a mask, a conductive impurity of n type conductivity is implanted into predetermined regions to form n⁺ regions 124. In a similar way, a conductive impurity of p type conductivity is implanted to form p⁺ regions 125. As a result, the structure shown in Fig. 26 is obtained.

After such an implantation step, an activation annealing process is performed. This activation annealing process can be performed under conditions that, for example, argon gas is employed as atmospheric gas, heating temperature is set at 1700°C, and heating time is set at 30 minutes.

Next, a gate insulating film forming step (S 140) is performed as shown in Fig. 24. Specifically, as shown in Fig. 27, oxide film 126 is formed to cover breakdown voltage holding layer 122, p regions 123, n⁺ regions 124, and p⁺ regions 125. As a condition for forming oxide film 126, for example, dry oxidation (thermal oxidation) may be performed. The dry oxidation can be performed under conditions that the heating temperature is set at 1200°C and the heating time is set at 30 minutes.

Thereafter, a nitrogen annealing step (S150) is performed as shown in Fig. 24. Specifically, an annealing process is performed in atmospheric gas of nitrogen monoxide (NO). Temperature conditions for this annealing process are, for example, as follows: the heating temperature is 1100°C and the heating time is 120 minutes. As a result, nitrogen atoms are introduced into a vicinity of the interface between oxide film 126 and each of breakdown voltage holding layer 122, p regions 123, n⁺ regions 124, and p⁺ regions 125, which are disposed below oxide film 126. Further, after the annealing step using the atmospheric gas of nitrogen monoxide, additional annealing may be performed using argon (Ar) gas, which is an inert gas. Specifically, using the atmospheric gas of argon gas, the additional annealing may be performed under conditions that the heating temperature is set at 1100°C and the heating time is set at 60 minutes.

Next, as shown in Fig. 24, an electrode forming step (S160) is performed. Specifically, a resist film having a pattern is formed on oxide film 126 by means of the photolithography method. Using the resist film as a mask, portions of the oxide film above n⁺ regions 124 and p⁺ regions 125 are removed by etching. Thereafter, a conductive film such as a metal is formed on the resist film and formed in openings of oxide film 126 in contact with n⁺ regions 124 and p⁺ regions 125. Thereafter, the resist film is removed, thus removing the conductive film's portions located on the resist film (lift-off). Here, as the conductor, nickel (Ni) can be used, for example. As a result, as shown in Fig. 28, source electrodes 111 and drain electrode 112 can be obtained. It should be noted that on this occasion, heat treatment for alloying is preferably performed. Specifically, using atmospheric gas of argon (Ar) gas, which is an inert gas, the heat treatment (alloying treatment) is performed with the heating temperature being set at 950°C and the heating time being set at 2 minutes.

Thereafter, on source electrodes 111, upper source electrodes 127 (see Fig. 23) are formed. Further, drain electrode 112 is formed on the backside surface of substrate 102 (see Fig. 23). Further, gate electrode 110 (see Fig. 23) is formed on oxide film 126. In this way, semiconductor device 101 shown in Fig. 23 can be obtained. In other words, semiconductor device 101 is fabricated by forming the epitaxial layers and the electrodes on SiC layer 20 of silicon carbide substrate 1.

It should be noted that in the seventh embodiment, the vertical type MOSFET has been illustrated as one exemplary semiconductor device that can be fabricated using the silicon carbide substrate of the present invention, but the semiconductor device that can be fabricated is not limited to this. For example, various types of semiconductor devices can be fabricated using the silicon carbide substrate of the present invention, such as a JFET (Junction Field Effect Transistor), an IGBT (Insulated Gate Bipolar Transistor), and a Schottky barrier diode. Further, the seventh embodiment has illustrated a case where the semiconductor device is fabricated by forming the epitaxial layer, which serves as an active layer, on the silicon carbide substrate having its main surface corresponding to the (03-38) plane. However, the crystal plane that can be adopted for the main surface is not limited to this and any crystal plane suitable for the purpose of use and including the (0001) plane can be adopted for the main surface.

The silicon carbide substrate of the present invention can be used to fabricate a semiconductor device as described above in the seventh embodiment. In other words, in the semiconductor device of the present invention, the epitaxial layer is formed on the silicon carbide substrate of the present invention as an active layer. More specifically, the semiconductor device of the present invention includes: the silicon carbide substrate of the present invention; the epitaxial growth layer formed on the silicon carbide substrate; and the electrodes formed on the epitaxial layer. Namely, the semiconductor device of the present invention includes: the plurality of SiC layers each made of single-crystal silicon carbide and arranged side by side when viewed in a planar view; the filling portion filling the gap between the plurality of SiC layers; the epitaxial layer formed on the SiC layer; and the electrodes formed on the epitaxial layer.

The embodiments disclosed herein are illustrative and non-restrictive in any respect. The scope of the present invention is defined by the terms of the claims, rather than the embodiments described above, and is intended to include any modifications within the scope and meaning equivalent to the terms of the claims.

### INDUSTRIAL APPLICABILITY

A method for manufacturing a silicon carbide substrate, and the silicon carbide substrate in the present invention are particularly advantageously applicable to a method for manufacturing a silicon carbide substrate, and the silicon carbide substrate, each of which is required to achieve both high crystallinity and a large diameter.

### REFERENCE SIGNS LIST

1, 2: silicon carbide substrate; 10: base layer (base substrate); 10A: main surface; 11: material substrate; 20: SiC layer (SiC substrate); 20A: main surface; 208: end surface; 30: epitaxial growth layer; 40: amorphous SiC layer; 41: Si layer; 60: filling portion; 70: intermediate layer; 71: precursor layer; 81: first heater; 82: second heater; 91: detachment facilitation region; 101: semiconductor device; 102: substrate; 110: gate electrode; 111: source electrode; 112: drain electrode; 121: buffer layer; 122: breakdown voltage holding layer; 123: p region; 124: n⁺ region; 125: p⁺ region; 126: oxide film; 127: upper source electrode.

## Claims

1. A method for manufacturing a silicon carbide substrate (1), comprising the steps of:
preparing a plurality of SiC substrates (20) each made of single-crystal silicon carbide;
forming a base layer (10) made of silicon carbide and holding said plurality of SiC substrates (20), which are arranged side by side when viewed in a planar view; and
forming a filling portion (60) filling a gap between said plurality of SiC substrates (20).

2. The method for manufacturing the silicon carbide substrate (1) according to claim 1, further comprising the step of smoothing main surfaces (20A) of said plurality of SiC substrates (20) opposite to said base layer (10) after the step of forming said filling portion (60).

3. The method for manufacturing the silicon carbide substrate (1) according to claim 1, further comprising the step of forming an epitaxial growth layer (30) made of single-crystal silicon carbide on main surfaces (20A) of said plurality of SiC substrates (20) opposite to said base layer (10).

4. The method for manufacturing the silicon carbide substrate (1) according to claim 1, wherein each of said plurality of SiC substrates (20) prepared in the step of preparing said plurality of SiC substrates (20) has an end surface (20B) corresponding to a cleavage plane thereof.

5. The method for manufacturing the silicon carbide substrate (1) according to claim 1, wherein each of said plurality of SiC substrates (20) prepared in the step of preparing said plurality of SiC substrates (20) has an end surface (20B) corresponding to a {0001} plane.

6. The method for manufacturing the silicon carbide substrate (1) according to claim 1, wherein in the step of forming said base layer (10), each of said SiC substrates (20) has a main surface (20A) opposite to said base layer (10) and having an off angle of not less than 50° and not more than 65° relative to a {0001} plane.

7. The method for manufacturing the silicon carbide substrate (1) according to claim 6, wherein in the step of forming said base layer (10), said main surface (20A) of each of said SiC substrates (20) opposite to said base layer (10) has an off orientation forming an angle of 5° or smaller relative to a <1-100> direction.

8. The method for manufacturing the silicon carbide substrate (1) according to claim 7, wherein in the step of forming said base layer (10), said main surface (20A) of each of said SiC substrates (20) opposite to said base layer (10) has an off angle of not less than -3° and not more than 5° relative to a {03-38} plane in the <1-100> direction.

9. The method for manufacturing the silicon carbide substrate (1) according to claim 1, wherein said filling portion (60) formed in the step of forming said filling portion (60) has an impurity concentration greater than 5 × 10¹⁸ cm⁻³.

10. The method for manufacturing the silicon carbide substrate (1) according to claim 1, further comprising the steps of:
forming a detachment facilitation region (91) by providing proton radiation to said SiC substrates (20) before the step of forming said base layer (10), so as to implant hydrogen ions into a region extending along a main surface of each of said SiC substrates (20) on which the base layer (10) is to be formed; and
detaching said SiC substrates (20) from said base layer (10) at said detachment facilitation region (91) after the step of forming said filling portion (60).

11. The method for manufacturing the silicon carbide substrate (1) according to claim 1, wherein the step of forming said base layer (10) is performed before the step of forming said base layer (10), without polishing a main surface of each of said SiC substrates (20) on which said base layer (10) is to be formed.

12. A silicon carbide substrate (1), comprising:
a plurality of SiC layers (20) each made of single-crystal silicon carbide and arranged side by side when viewed in a planar view; and
a filling portion (60) filling a gap between said plurality of SiC layers (20).

13. The silicon carbide substrate (1) according to claim 12, wherein said filling portion (60) has an impurity concentration greater than 5 × 10¹⁸ cm⁻³.

14. The silicon carbide substrate (1) according to claim 12, further comprising a base layer (10) made of silicon carbide and holding said plurality of SiC layers (20), which are arranged side by side when viewed in a planar view.

15. The silicon carbide substrate (1) according to claim 14, wherein a main surface (20A) of each of said SiC layers (20) opposite to said base layer (10) is polished.

16. The silicon carbide substrate (1) according to claim 12, further comprising an epitaxial growth layer (30) made of single-crystal silicon carbide and formed on main surfaces (20A) of said plurality of SiC layers (20).

17. The silicon carbide substrate (1) according to claim 12, wherein each of said plurality of SiC layers (20) has an end surface (20B) corresponding to a cleavage plane thereof.

18. The silicon carbide substrate (1) according to claim 12, wherein each of said plurality of SiC layers (20) has an end surface (20B) corresponding to a {0001} plane.

19. The silicon carbide substrate (1) according to claim 12, wherein each of said SiC layers (20) has a main surface (20A) having an off angle of not less than 50° and not more than 65° relative to a {0001} plane.

20. The silicon carbide substrate (1) according to claim 19, wherein said main surface (20A) of each of said SiC layers (20) has an off orientation forming an angle of 5° or smaller relative to a <1-100> direction.

21. The silicon carbide substrate (1) according to claim 20, wherein said main surface (20A) of each of said SiC layers (20) has an off angle of not less than -3° and not more than 5° relative to a {03-38} plane in the <1-100> direction.
